# EUROPEAN PATENT SPECIFICATION

(11) **EP 0 224 993 B1**
(45) Date of publication and mention of the grant of the patent: **15.12.1993**
(21) Application number: 86306796.3
(22) Date of filing: 03.09.1986
(51) Int. Cl.: H01L 27/14

(54) **A method of operating a solid-state image sensor**
Verfahren zum Betreiben eines Festkörperbildsensors
Méthode pour faire fonctionner un capteur d'images à état solide

(30) Priority: 25.11.1985 JP 266759/85
(43) Date of publication of application: 10.06.1987
(73) Proprietor: SHARP KABUSHIKI KAISHA, Osaka 545 (JP)
(72) Inventor: Miyatake, Shigehiro, Osaka (JP)
(74) Representative: Billington, Lawrence Emlyn

(56) References cited:
- EP-A- 0 173 542
- US-A- 4 498 013
- IEEE INTERNATIONAL SOLID-STATE CIRCUITS CONFERENCE, vol. 28, 13th February 1985, pages 98,99, IEEE, Coral Gables, Florida, US; T. NAGAKAWA et al.: "A 580 x 500-element CCD imager with a shallow flat P well"
- IEEE TRANSACTIONS ON ELECTRON DEVICES, vol. ED-31, no. 12, pages 1829-1833, IEEE, New York, US; N. TERANISHI et al.: "An interline CCD image sensor with reduced image lag"
- IEEE Transactions on Electron Devices, vol. ED-31, no. 1, January 1984, pages 83-88 ; Y. Ishihara et al. : "Interline CCD Image Sensor with an Antiblooming Structure"

## Description

This invention relates to a method of operating a solid-state image sensor, especially an interline CCD image sensor (i.e., an interline-transfer charge-coupled device image sensor).

Although solid-state image sensors are advantageous over pick-up tubes in compactness, minimization of weight, durability, reliability, etc., and moreover they exhibit no burn-in from intense overloads, they give rise to blooming and smear which do not arise in pick-up tubes. Blooming occurs when excess signal charges in the photodiode overflow into the transfer channel, resulting in distinct white lines on the obtained image, while smear takes place when a signal charge generated deep inside the substrate diffuses into the transfer channel, resulting in indistinct white lines on the obtained image. Blooming can be eliminated by means of overflow drains composed of an n⁺-diffusion layer which absorbs excess charges. However, the problem of smear has not yet been solved.

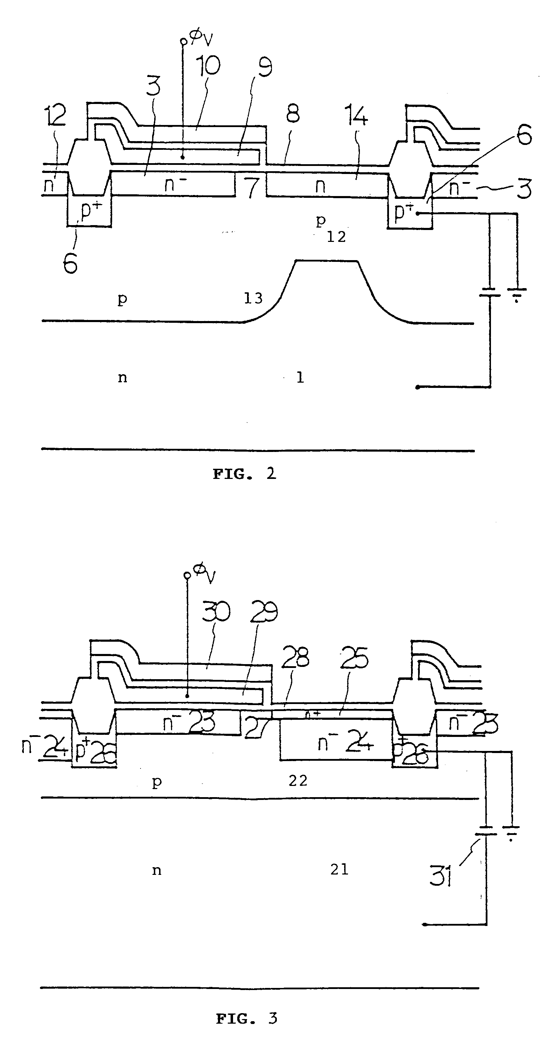

The above-mentioned approach for the elimination of blooming sacrifices photosensitivity and dynamic range because the active area is reduced, and accordingly a method for the transfer of the excess charges into the substrate has been proposed by Y. Ishihara et al., "Interline CCD Image Sensor with an Antiblooming Structure", IEEE Transactions on Electron Devices, vol. ED-31, No. 1, January 1984. Figure 2 shows a unit cell of the interline CCD image sensor described in the above-mentioned article, wherein an n⁻-layer 3 constituting a buried channel of the vertical CCD register is formed on a thick p-type layer **13**, while an n-type layer **14** constituting a p-n junction photodiode as a photosensitive area is formed on a thin p-type layer **12**. Both the thick p-type layer **13** and the thin p-type layer **12** are positioned on an n-type substrate **1**. A transfer gate region **7** positioned between the n⁻-layer **3** and n-type layer **14** contains the part of the p-type layer which has not undergone depletion. This unit cell is electrically isolated from adjacent unit cells by channel stops **6** composed of p⁺-layers formed in the surroundings thereof. On the n⁻-layer **3** and the transfer gate region **7**, a polysilicon electrode **9**, which is an electrode for the vertical CCD register to be driven by pulses **φv** fed to the electrode **9**, is formed. On the polysilicon electrode **9**, an Al film **10** is further formed as a photo-shield.

A reverse bias voltage is applied between the channel stops **6** and the n-type substrate **1**, resulting in a complete depletion of the thin p-type layer **12**.

The pulses **φv** have three levels, V_{H} (high), V_{M} (middle) and V_{L} (low). When the pulses **φv** are between the V_{M} and V_{L} levels, the n⁻-layer **3** constituting the vertical CCD register area is isolated from the n-type layer **14** constituting the photosensitive area by the transfer gate region **7** containing a part of the p-type layer. When the pulses **φv** are at the highest potential V_{H}, a signal charge is accumulated into the photosensitive area and transferred from the photosensitive area into the vertical CCD register area through the transfer gate region **7**, and the potential of the n-type layer **14** constituting the photosensitive area results in a level equal to the surface potential of the transfer gate region **7**. This signal charge is further transferred to a horizontal CCD register (not shown) to be read out at a gated charge detector (not shown).

As the photogenerated signal charge is accumulated into the n-type layer **14**, the potential of the n-type layer **14** decreases. The excess charges generated in the n-type layer **14** receiving intense illuminnation thereto are transferred from the n-type layer **14** into the n-type substrate **1** through the thin p-type layer **12** which has been depleted, resulting in a suppression of blooming.

As mentioned above, the conventional image sensor shown in Figure 2 can suppress blooming, but it still has the following serious problems:

The first problem is that the image sensor cannot be made compact because of the transverse expansion of the thick p-type layer **13**. The size of the unit cell cannot be minimized beyond a certain extent in the transverse direction because the size of the thin p-layer **12** is essential to a certain extent.

The second problem is that smear takes place unavoidably when a signal charge generated in the non-depletive thick p-type layer **13** diffuses into the vertical CCD register and mixes with the signal charge in the vertical CCD register.

In order to eliminate these problems, the inventor of this invention has proposed a solid-state image sensor having a plurality of unit cells by EP-A-0 173 542, (a document forming part of the state of the art according to Article 54 (3) EPC see also IEEE International Solid State Circuits Conference 28 (1985) Febr., 32nd Conf., Coral Gables, Florida, U.S.A, pages 98 and 99) wherein each of the unit cells comprises a photosensitive area and a CCD register for the transfer of a signal charge generated in said photosensitive area, both said photosensitive area and said CCD register are disposed on a layer, having a different polarity from the charging polarity of said signal charge, which is disposed on a substrate having the same polarity as said signal charge. The photosensitive area has the same polarity as said signal charge, resulting in a suppression of blooming.

Figure 3 shows a unit cell of the interline CCD image sensor of the above-mentioned EP Patent Application, which comprises an n-type substrate **21**, a p-type layer **22** formed on the n-type substrate **21**, a vertical CCD register which is composed of a buried channel constituted by an n⁻-layer **23** formed on the p-type layer **22**, and a photosensitive area which contains a p-n junction photodiode constituted by an n⁻-layer **24** and an n⁺-layer **25**.

A transfer gate region **27** containing a part of the p-type layer is positioned between the n⁻-layer **23** and the n⁺-layer **25**. This unit cell is isolated from adjacent unit cells by channel stops 26 composed of p⁺-layers formed in the surroundings thereof. On the n⁻-layer **23** and the transfer gate region **27**, the polysilicon electrode **29** functioning as an electrode for the CCD register which is driven by pulses **φv** fed to the electrode **29** is disposed through an insulating film **28**. On the polysilicon electrode **29**, an Al film **30** is disposed as a photo-shield.

A reverse bias voltage is applied between the channel stop **26** and the n-type substrate **21**, resulting in complete depletion not only in the region of the p-type layer positioned between the substrate **21** and the CCD register, but also in the region of the p-type layer positioned between the substrate **21** and the photodiode area.

The introduction of the pulses **φv** (having three potential levels, V_{H}, V_{M}, and V_{L}) into the polysilicon electrode of the image sensor having the above-mentioned structure, the reading out of a signal charge at a gate transfer detector, the control of the transfer of the signal charge into the CCD register, and the control of the accumulation of the signal charge in the photosensitive area are attained in the same manner as for a conventional image sensor. Since the region of the p-type layer positioned below the photodiode area has been depleted, excess charges generated in the photodiode area receiving intense illumination are transferred from the photodiode area into the n-type substrate **21** through the n⁻-layer **24** and the p-type layer **22** in the same manner as the conventional image sensor in Figure 2, resulting in a suppression of blooming. Due to the above-mentioned structure of the image sensor, the region of the p-type layer **22** positioned below the n⁻-layer **23** is also depleted and charges generated deep inside said region can be transferred from said region into the n-type substrate **21** without diffusion of the charges into the CCD register, so that smear can be completely suppressed. Moreover, the transverse expansion of the thick p-type layer required in a conventional image sensor is not required in above-mentioned image sensor, so that compactness of the image sensor can be achieved.

However, the unit cell shown in Figure 3 is designed such that both the buried channel CCD register and the photosensitive area are disposed on the same p-type well, which causes the following problem: When reverse bias voltage is applied between the n-type substrate **21** and the p-type well **22** at a low level, electrons are injected from the n-type substrate **21** into the buried channel CCD register **23** in the p-type well **22** formed on the n-type substrate **21** (S. Miyatake et al., "A CCD Imager on Three Types of P-Wells", Jpn. J. Appl. Phys., vol. 24, pp. 574-579, May 1985), resulting in electrons in the CCD register. The lower the impurity concentration of the p-type well **22**, the higher the injection voltage of the CCD register becomes. Thus, in order to suppress such an injection of electrons, the impurity concentration of the p-type well **22** must be set at a high level. When the impurity concentration of the p-type well **22** is too high, excess charges generated in the photosensitive area receiving intense illumination cannot be transferred from the photosensitive area into the n-type substrate **21** through the p-type well **22**, causing blooming. As mentioned above, the proposed structure of a unit cell of the interline CCD image sensor attains a suppression of smear and compactness, but the impurity concentration of the p-type well **22** must be set so that excess charges in the photodiode area overflow into the n-type substrate **21** through the p-type well **22** and so that electrons are not injected from the n-type substrate **21** into the buried channel CCD register **23**, which causes a limitation of the impurity concentration of the p-type well **22**.

IEEE Transactions on Electron Devices, ED-31(1984), Dec., No. 12, New York, USA, pages 1829 to 1833, "An Interline CCD Image Sensor with Reduced Image Lag", discloses a device with a unit cell similar to that of Figure 2 but having a p⁺-n layer structure in place of the n-type layer 14 of Fig. 2. This p⁺-n layer structure is said to reduce image lag.

US-A-4 498 013 discloses an image sensor which, like the device of Fig. 3 has a single p-type layer rather than both a thick and a thin p-type layer.

The single p-type layer of the sensor of the US document is not completely depleted either in the region between the substrate and the CCD register or in the region between the substrate and the photosensitive area.

The photosensitive area of the sensor of the US document contains a p-n junction constituted by an n⁺-layer and said single p-type layer.

The vertical CCD register of the sensor of the US document comprises an n⁻-type layer and said single p-type layer, with an interposed p⁺-type region. The p⁺-type region provides a potential barrier around the depletion layer of the vertical CCD register to prevent noise component electric charges generated in the single p-type layer from being introduced into the depletion layer of the vertical CCD register.

The sensor of the US document has no channel stop regions.

According to the present invention there is provided a method of operating solid-state image sensor according to claim 1.

The impurity concentration in the surface region of the photosensitive area is preferably higher than that in the region of the photosensitive area nearer the substrate and may be formed by a self-alignment technique using the electrode for the CCD register as a mask.

Depletion is in the invention attained not only in the region of the first layer between the substrate and the photosensitive area but also in the region of the first and second layers between the substrate and the CCD register, by the application of a reverse bias voltage between the substrate and the first layer.

The CCD register advantageously comprises a buried channel, the formation of which may advantageously be simultaneous with the formation of the part of the photosensitive area nearer the substrate.

Thus, an embodiment of the invention described herein makes possible: (1) providing a method of operating a solid-state image sensor which can attain a suppression of not only blooming but also smear; (2) providing a method of operating a solid-state image sensor having a compact structure; and (3) providing a method of operating a solid-state image sensor in which the impurity concentration of the p-type well on which the photosensitive area and the buried-channel CCD register are disposed is set at a selected level so that limitations in the design and the production of the sensor can be reduced thereby attaining an efficient production of the sensor.

For a better understanding of the invention, an embodiment will now be described with reference to the accompanying drawings, in which:
Figure 1 is a sectional view showing a unit cell of a solid-state image sensor operable in accordance with this invention;
Figure 2 is a sectional view showing a conventional unit cell of an interline CCD image sensor.
Figure 3 is a sectional view showing a prior unit cell of another interline CCD image sensor.

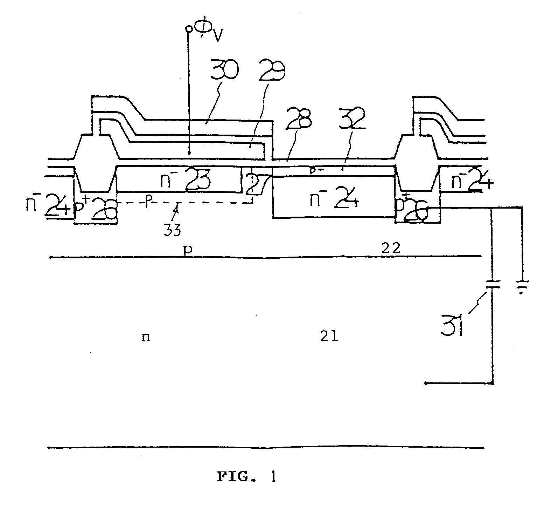

Figure 1 shows a unit cell of an interline CCD image sensor operable according to this invention, which comprises an n-type substrate 21, a p-type first layer 22 formed on the n-type substrate 21, vertical CCD register which is composed of a buried channel constituted by an n⁻-layer 23 formed on the p-type layer 22 associated with a polysilicon electrode 29, and a photosensitive area which contains a p-n junction photodiode constituted by an n⁻-layer 24 and the first layer 22. The n⁻-layer 23 is underlain by a p-type second layer 33, the impurity concentration of which is higher than that of the p-type first layer 22. The p+-layer 32 is positioned in the region of the outer surface of the photosensitive area, while the n⁻-layer 24 is positioned in the region of the photosensitive area nearer the n-type substrate 21. Since the p+-layer 32 can be formed by a self-alignment technique using the polysilicon electrode 29 as a mask, it allows simplification of the production process of this image sensor. Moreover, since the n⁻-layer 24 can be formed at the same time as the n⁻-layer 23 constituting the buried channel, this also leads to simplification of the production processes of this image sensor.

A transfer gate region 27 containing a part of the p-type layer 22 is positioned between the n⁻-layer 23 and the p+- layer 32. The unit cell is isolated from adjacent unit cells by channel stops 26 composed of p+-layers formed in the surroundings thereof. The polysilicon electrode 29, functioning as an electrode for the CCD register which is driven by pulses φ**v** fed to the electrode 29, is disposed on an insulating film 28 covering the n⁻-layer 23 and the transfer gate. On the polysilicon electrode 29 an Al film 30 is disposed as a photo-shield.

When the pulses φ**v** are at the highest potential level V_{H} and the signal charge accumulated in the photosensitive area is read out at the horizontal CCD register, the n⁻-layer 24 is completely depleted because the p+-layer 32 is formed with a high impurity concentration and positioned at the same potential as the p+-channel stop layer 26.

A reverse bias voltage is applied between the channel stop 26 and the n-type substrate 21, resulting in complete depletion not only in the region of the p-type layer positioned between the substrate 21 and the CCD register, but also in the region of the p-type layer positioned between the substrate 21 and the photodiode area.

The introduction of the pulses φ**v** (having three potential levels, V_{H}, V_{M}, and V_{L}) into the polysilicon electrode of the image sensor having the above-mentioned structure, the reading out of a signal charge at a gate transfer detector, the control of the transfer of the signal charge into the CCD register, and the control of the accumulation of the signal charge in the photosensitive area are attained in the same manner as for a conventional image sensor. Since the region of the p-type layer positioned below the photodiode area is depleted, excess charges generated in the photodiode area receiving intense illumination are transferred from the photodiode area into the n-type substrate **21** through the n⁻-layer **24** and the p-type layer **22** in the same manner as the conventional image sensor in Figure **2**, resulting in a suppression of blooming. Moreover, since the n⁻-layer **23** constituting the buried channel CCD register is underlaid by the p-type layer **33**, when the p-type layer **33** contains a high impurity concentration, the injection of electrons from the n-type substrate **21** into the buried channel CCD register **23** can be easily prevented. The region of the p-type layer **22** positioned below the n⁻-layer **23** is also depleted and charges generated deep inside said region can be transferred from said region into the n-type substrate **21** without diffusion of the charges into the CCD register, so that smear can be completely suppressed. Moreover, the transverse expansion of the thick p-type layer required in a conventional image sensor is not required in above-mentioned image sensor operable according to this invention, so that compactness of the image sensor can be achieved.

As mentioned above, each of the unit cells of image sensor operable according to this invention is designed in a manner to form both the buried channel CCD register of the n⁻-layer constituting the transfer area and the photodiode constituting the photosensitive area on the same p-type layer disposed on the n-type substrate, so that excess charges generated in the photodiode receiving intense illumination can be transferred from the photodiode into the n-type substrate through the depleted region of the p-type layer therebetween, resulting in a suppression of blooming. Moreover, the impurity concentration of the p-type layer positioned below the buried channel CCD register can be set at a higher level than that of the p-type layer positioned below the photodiode, provided that excess charges in the photodiode overflow into the n-type substrate **21** through the p-type well **22** and that electrons are not injected from the n-type substrate **21** into the buried channel CCD register **23**. Moreover, since not only the photodiode area but also the CCD register are formed on the thin p-type well, the region of the p-type well positioned below the CCD register can be depleted and charges generated deep inside the depleted region of the p-type well do not diffuse into the CCD register, resulting in a suppression of smear.

Since the image sensor operable according to this invention has only one p-type layer **22**, on which both the CCD register and the photodiode are formed, and does not have such thick p-type layer **13** expanding transversely as in the conventional image sensor in Figure **2**, it can be made compact, whereas the conventional image sensor cannot be made compact because of the transverse expansion of the said thick p-type layer **13**.

## Claims

1. A method of operating a solid-state image sensor having a plurality of unit cells, each of which comprises:-
a photosensitive area (24, 32),
a CCD register (23) for the transfer of a signal charge generated in the photosensitive area,
and a channel stop layer (26) surrounding the cell,
wherein both the photosensitive area (24, 32) and the CCD register (23) are disposed on a first layer (22) disposed on a substrate (21), which first layer (22) has a polarity different from that of the substrate (21) which has the same polarity as the signal charge,
wherein the region of the outer surface of the photosensitive area (24, 32) contains a layer (32) having a different polarity from the charging polarity of the signal charge and the region of the photosensitive area nearer the substrate (21) contains a layer (24) having the same polarity as the signal charge, and
wherein a second layer (33) having the same polarity as the first layer (22) and containing the impurity in a higher concentration than the first layer is disposed under the CCD register (23),
characterised in that a reverse bias voltage is applied between the channel stop layer (26) and the substrate (21) so that the region of the first layer (22) between the substrate (21) and the photosensitive area (24, 32) is completely depleted, and the region of the first layer (22) between the substrate (21) and the CCD register (23) is completely depleted, and also said second layer (33) is completely depleted.

2. A method according to calim 1, wherein the impurity concentration of the said outer layer (32) of the image sensor is higher than that in the region (24) of the photosensitive area nearer the substrate.

3. A method according to claim 1 or 2, wherein the CCD register (23) of the image sensor comprises a buried channel.

4. A method according to any preceding claim, wherein the channel stop layer (26) of the image sensor has a different polarity from the charging polarity of the signal charge, and the said surface layer (32) of the image sensor has the same potential as the channel stop layer (26).

5. A method according to claim 4, wherein the second layer (33) of the image sensor is in contact with the channel stop layer (26) of the image sensor.

6. A method according to claim 4 or 5, wherein the channel stop layer (26) of the image sensor is grounded.

## Patentansprüche

1. Verfahren zum Betreiben eines Festkörper-Bildsensors mit einer Anzahl von Einheitszellen, von denen jede aufweist:
- ein fotoempfindliches Gebiet (24, 32),
- ein CCD-Register (23) zum Übertragen einer Signalladung, die in dem fotoempfindlichen Gebiet erzeugt wurde,
- und eine Kanalstopschicht (26), die die Zelle umgibt,
- wobei sowohl das fotoempfindliche Gebiet (24, 32) als auch das CCD-Register (23) auf einer ersten Schicht (22) angeordnet sind, die auf einem Substrat (21) liegt, wobei die erste Schicht (22) eine andere Polarität als das Substrat (21) hat, das die gleiche Polarität wie die Signalladung aufweist,
- wobei der Bereich der äußeren Fläche des fotoempfindlichen Gebiets (24, 32) eine Schicht (32) enthält, die eine andere Polarität als die Ladepolarität der Signalladung hat und wobei der Bereich des fotoempfindlichen Gebiets näher dem Substrat (21) eine Schicht (24) aufweist, die die gleiche Polarität wie die Signalladung besitzt und
- wobei eine zweite Schicht (33) die gleiche Polarität wie die erste Schicht (22) aufweist und die Verunreinigung in einer höheren Konzentration als die erste Schicht unter dem CCD-Register (23) enthält,
- **dadurch gekennzeichnet**, daß eine Umkehrvorspannung zwischen die Kanalstopschicht (26) und das Substrat (21) derart angelegt ist, daß der Bereich der ersten Schicht (22) zwischen dem Substrat (21) und dem fotoempfindlichen Gebiet (24, 32) vollständig verarmt ist und der Bereich der ersten Schicht (22) zwischen dem Substrat (21) und dem CCD-Register (23) vollständig verarmt ist und daß auch die zweite Schicht (33) vollständig verarmt ist.

2. Verfahren nach Anspruch 1, wobei die Verunreinigungskonzentration in der äußeren Schicht (32) des Bildsensors höher als in dem Bereich (24) des fotoempfindlichen Gebiets ist, der näher dem Substrat liegt.

3. Verfahren nach Anspruch 1 oder 2, wobei das CCD-Register (23) des Bildsensors einen eingebetteten Kanal aufweist.

4. Verfahren nach einem der vorhergehenden Ansprüche, wobei die Kanalstopschicht (26) des Bildsensors eine andere Polarität als die Ladepolarität der Signalladung hat und wobei die Oberflächenschicht (32) des Bildsensors das gleiche Potential wie die Kanalstopschicht (26) hat.

5. Verfahren nach Anspruch 4, wobei die zweite Schicht (33) des Bildsensors in Kontakt mit der Kanalstopschicht (26) des Bildsensors steht.

6. Verfahren nach Anspruch 4 oder 5, wobei die Kanalstopschicht (26) des Bildsensors geerdet ist.

## Revendications

1. Méthode pour faire fonctionner un capteur d'images à état solide présentant une pluralité de cellules unités, dont chacune comporte:
une zone photosensible (24, 32),
un registre CCD (23) pour le transfert d'une charge, représentant un signal, générée dans la zone photosensible,
et une couche d'arrêt de canal (26) entourant la cellule,
cellule dans laquelle la zone photosensible (24, 32) et le registre CCD (23) sont l'un et l'autre disposés sur une première couche (22) disposée sur un substrat (21), laquelle première couche (22) présente une polarité différente de celle du substrat (21) lequel a lui-même la même polarité que la charge représentant le signal,
dans laquelle la région de la surface extérieure de la zone photosensible (24, 32) contient une couche (32) présentant une polarité différente de la polarité de chargement de la charge représentant le signal tandis que la région de la zone photosensible plus proche du substrat (21) contient une couche (24) présentant la même polarité que la charge représentant le signal, et
dans laquelle une seconde couche (33), présentant la même polarité que la première couche (22) et contenant des impuretés en concentration plus élevée que la première couche, est disposée sous le registre CCD (23),
méthode caractérisée par le fait qu'une tension de polarisation inverse est appliquée entre la couche (26) d'arrêt de canal et le substrat (21) de sorte que la région de la première couche (21) située entre le substrat (21) et la zone photosensible (24, 32) est complètement appauvrie et que la région de la première couche (22) située entre le substrat (21) et le registre CCD (23) est complètement appauvrie et que ladite seconde couche (33) est également complètement appauvrie.

2. Méthode selon la revendication 1, dans laquelle la concentration en impuretés de ladite couche extérieure (32) du capteur d'images est plus élevée que celle de la région (24) de la zone photosensible plus proche du substrat.

3. Méthode selon **la revendication** 1 ou 2, dans laquelle le registre CCD (23) du capteur d'images comporte un canal enterré.

4. Méthode selon l'une quelconque des revendications précédentes, dans laquelle la couche (26) d'arrêt de canal du capteur d'images présente une polarité différente de la polarité de chargement de la charge représentant le signal et dans laquelle ladite couche de surface (32) du capteur d'images présente le même potentiel que la couche (26) d'arrêt de canal.

5. Méthode selon la revendication 4, dans laquelle la seconde couche (33) du capteur d'images est en contact avec la couche (26) d'arrêt de canal du capteur d'images.

6. Méthode selon **la revendication** 4 ou 5, dans laquelle la couche (26) d'arrêt de canal du capteur d'images est mise à la masse.
